# EUROPÄISCHE PATENTSCHRIFT

(11) **EP 4 215 018 B1**
(45) Veröffentlichungstag und Bekanntmachung des Hinweises auf die Patenterteilung: **29.07.2026**
(21) Anmeldenummer: 21752497.4
(22) Anmeldetag: 05.08.2021
(51) Int. Cl.: H05B 3/86, H10K 71/60, H10K 77/10, H10H 20/833

(54) **TRANSPARENTE, LEITFÄHIGE FOLIE, VERFAHREN ZUM HERSTELLEN DERSELBEN UND VERWENDUNG**
TRANSPARENT CONDUCTIVE FILM, METHOD FOR PRODUCING SAME, AND USE
FILM CONDUCTEUR TRANSPARENT, SON PROCÉDÉ DE PRODUCTION ET SON UTILISATION

(30) Priorität: 15.09.2020 DE 102020005643
(43) Veröffentlichungstag der Anmeldung: 26.07.2023
(73) Patentinhaber: Giesecke+Devrient Currency Technology GmbH, 81677 München (DE)
(72) Erfinder: GOTTSCHLING, Kerstin, 82024 Taufkirchen (DE); HUNGER, Christoph, 83734 Hausham (DE); LENSSEN, Daniel, 81829 München (DE)
(74) Vertreter: Giesecke+Devrient IP
(86) Internationale Anmeldenummer: PCT/EP2021/025300
(87) Internationale Veröffentlichungsnummer: WO 2022/058041

(56) Entgegenhaltungen:
- EP-A1- 4 013 188
- US-A1- 2014 218 325
- K. D. M. RAO ET AL: "A cracked polymer templated metal network as a transparent conducting electrode for ITO-free organic solar cells", 9 June 2014 (2014-06-09), pages 15107 - 15110, XP055291180, Retrieved from the Internet <URL:http://pubs.rsc.org/en/content/articlehtml/2014/cp/c4cp02250e> [retrieved on 20160726], DOI: 10.1039/c4cp02250e

## Beschreibung

Die Erfindung betrifft eine transparente, leitfähige Folie, ein Verfahren zum Herstellen derselben und eine Verwendung.

Transparente, leitfähige Folien, die z.B. als Heizelemente für Windschutzscheiben von Fahrzeugen geeignet sind, wurden im Stand der Technik beschrieben, siehe z.B. die EP 2764996 B1, die EP 2284134 B1 und die WO 2016/192858 A1. Gemäß der WO 2016/192858 A1 erfolgt die Herstellung einer transparenten, leitfähigen Folie auf Grundlage eines mehrstufigen Verfahrens, bei dem zunächst auf einem transparenten Trägersubstrat eine abwaschbare Beschichtung aufgebracht wird, die beim Trocknen zahlreiche Risse in Form eines dichtmaschigen, zusammenhängenden Netzes ausbildet. Anschließend erfolgt das Bedampfen mit Metall, gefolgt von einem Entfernen der mit Rissen versehenen, abwaschbaren Beschichtung in einem Waschschritt. Das erhaltene Erzeugnis ist so beschaffen, dass es oberhalb des Trägersubstrats eine transparente, leitfähige Metallisierung in Form eines dichtmaschigen, zusammenhängenden Netzes aufweist.

K. D. M. Rao, C. Hunger, R. Gupta, G. U. Kulkarni, M. Thelakkat: "A cracked polymer templated metal network as a transparent conducting electrode for ITO-free organic solar cells", Phys. Chem. Chem. Phys., 2014, Band 16, Seiten 15107-15110; beschreibt ein hochtransparentes, widerstandsarmes Ag-Metallnetzwerk, das durch eine rissige Polymer-Dünnschicht modelliert wurde, und dessen Einbau in eine organische Solarzelle.

US 2014/218325 A1, ein Familienmitglied der EP 2764996 B1, beschreibt eine leitfähige Folie, umfassend eine Basis; und einen leitfähigen Abschnitt, der auf mindestens einer Hauptoberfläche der Basis ausgebildet ist und aus einer Vielzahl dünner Metalldrähte gebildet ist, wobei durch den leitfähigen Abschnitt ein Gittermuster gebildet wird, in dem eine Vielzahl von Öffnungen mit unterschiedlichen Formen in der Draufsicht angeordnet sind, und eine Standardabweichung einer Fläche jeder der mehreren Öffnungen gleich oder größer als 0,017 mm² und gleich oder kleiner als 0,038 mm² ist.

In der Praxis hat sich gezeigt, dass insbesondere bei Kuper-basierten Metallisierungen der rötliche Farbeindruck des Metalls auf einer transparenten Folie optisch auffällig und somit für den Betrachter störend ist. Im Falle weiterer Metalle, z.B. Aluminium oder Silber, ist bei der Betrachtung im Auflicht oder im Durchlicht eine stark reflektierende Metalloberfläche wahrnehmbar, im Glanzwinkel vor allem als Glanz.

Der vorliegenden Erfindung liegt die Aufgabe zugrunde, die im Stand der Technik bekannte transparente, leitfähige Folie zu verbessern. Insbesondere soll eine transparente, leitfähige Folie bereitgestellt werden, die verglichen mit den bislang bekannten Folien einen neutralen Farbeindruck aufweist. Diese Aufgabe wird durch die in den unabhängigen Ansprüchen definierten Merkmalskombinationen gelöst. Weiterbildungen der Erfindung sind Gegenstand der Unteransprüche.

### Ausführliche Beschreibung der Erfindung

Die vorliegende Erfindung basiert auf der aus der WO 2016/192858 A1 bekannten Technologie zur Feinstrukturierung von Metallisierungen, auf deren Grundlage elektrische Vorrichtungen, z.B. Heizfolien zur Verwendung in der Windschutzscheibe eines Fahrzeugs, bereitgestellt werden können. Zur Technologie gehört u.a. die Verwendung einer Riss-bildenden Beschichtung, bevorzugt eine Dispersion oder eine Lösung eines Polymers. Die Riss-bildende Beschichtung wird auf das transparente Substrat aufgebracht, z.B. mittels Aufdrucken, sodass ein dünner Film erzeugt wird, der während des Trocknens Risse in Form eines dichtmaschigen, zusammenhängenden Netzes ausbildet. Anschließend erfolgt das Bedampfen mit Metall, gefolgt von einem Entfernen der mit Rissen versehenen, abwaschbaren Beschichtung in einem Waschschritt. Das erhaltene Erzeugnis ist so beschaffen, dass es oberhalb des transparenten Substrats eine transparente, leitfähige Metallisierung in Form eines dichtmaschigen, zusammenhängenden Netzes aufweist.

Der vorliegenden Erfindung liegt die Erkenntnis zugrunde, dass insbesondere bei Kupfer-basierten Systemen der rötliche Farbeindruck des Metalls oberhalb eines transparenten Substrats stark wahrnehmbar ist. Im Falle anderer Metall-basierter Systeme, z.B. Aluminium oder Silber, ist im Auflicht oder im Gegenlicht eine stark reflektierende Metalloberfläche, vor allem im Glanzwinkel als Glanz, wahrnehmbar. Erfindungsgemäß wurde festgestellt, dass ein neutraler Farbeindruck mit geringer Reflexion herbeigeführt werden kann, indem man das metallische Netzwerk in Form einer Mehrschichtanordnung ausgestaltet, die eine erste Schicht aus Kupfer und zumindest eine weitere Schicht aus einem die visuelle Wahrnehmbarkeit der ersten Schicht verringernden Material aufweist. Die erfindungsgemäße transparente, leitfähige Folie erzielt infolge des neutralen Farbeindrucks und die nicht-reflektierenden Metalloberflächen eine höhere Transparenz und eine geringere Wahrnehmbarkeit durch den Betrachter. Des Weiteren ist das erfindungsgemäße Herstellungsverfahren technisch in einfacher Weise ausführbar, weil die zusätzlichen Schichten flächendeckend auf die mit Rissen versehene, abwaschbare Beschichtung aufgebracht und anschließend in einem Waschschritt weggewaschen werden können. Entweder die wahrnehmbare Farbe oder die wahrnehmbare Reflexion oder beides gleichzeitig kann durch eine geeignete Wahl des die visuelle Wahrnehmbarkeit des metallischen Netzwerks verringernden Materials gesteuert werden.

Hierin wird unter einer Betrachtung eines Gegenstands im Auflicht die Konstellation verstanden, dass sowohl die Beleuchtung als auch die Betrachtung des Gegenstands von derselben Seite des Gegenstands erfolgen, wohingegen im Falle einer Betrachtung des Gegenstands im Durchlicht bzw. Gegenlicht die Beleuchtungsquelle und der Betrachtungsort auf gegenüber liegenden Seiten des Gegenstands angeordnet sind.

Für das Erzielen der vorteilhaften Wirkung des Verringerns der visuellen Wahrnehmbarkeit des metallischen Netzwerks aus Kupfer eignet sich insbesondere ein Material, das von der Gruppe bestehend aus einer Metalloxidschicht, vorzugsweise eine auf Kupferoxid, Chromoxid oder eine auf unterstöchiometrischem Aluminiumoxid basierende Metalloxidschicht, einem antireflektierenden Dünnschichtaufbau mit insbesondere der Schichtenfolge Metall/Dielektrikum/Metall (z.B. ein Cu/SiO₂/Cr-Aufbau) oder der Schichtenfolge Dielektrikum/Metall/Dielektrikum/Metall (z.B. ein SiO₂/Cr/SiO₂/Al-Aufbau, ein SiO₂/Cr/SiO₂/Cu-Aufbau oder ein SiO₂/Al/SiO₂/Cu-Aufbau),
Schwarzchrom (d.h. schwarz passiviertes Chrom), Schwarznickel (d.h. schwarz passiviertes Nickel), einer Metallsulfidschicht, einem auf einem Farblack oder einem Pigmentlack basierenden Überdruck, einer durch eine Nanostrukturierung bzw. Mottenaugenstruktur gebildete Antireflexionsschicht und einer Kombination zweier oder mehrerer der vorstehend genannten Elemente gewählt ist.

Antireflektierende Dünnschichtaufbauten sind im Stand der Technik bekannt, siehe z.B. Sang-Hwan Cho et al., Journal of theKorean Physical Society, Vol. 55, No. 2, August 2009, 501 - 507.

Dünnschichtelemente mit Mehrschichtstruktur mit einem dunkel erscheinenden nanostrukturierten Bereich (sogenannte Mottenaugenstruktur) sind z.B. aus der EP 2 453 269 A1 bekannt. Eine durch eine Nanostrukturierung gebildete Antireflexionsschicht basiert insbesondere auf einem Metall, z.B. Cu, einem Metalloxid, einem Nitrid, einem Polymer oder auf einem Dielektrikum.

Gemäß einer bevorzugten Ausführungsform wird die leitfähige Metallisierung in Form eines dichtmaschigen, zusammenhängenden Netzes so ausgebildet, dass ausgehend vom transparenten Substrat eine erste Schicht aus Kupfer und darauffolgend zumindest eine weitere Schicht aus dem die visuelle Wahrnehmbarkeit der ersten Schicht verringernden Material in der Reihenfolge angeordnet sind. Bei Bedarf kann der Aufbau zusätzlich mit einer transparenten, die leitfähige Metallisierung einebnenden Beschichtung, z.B. ein UV-härtender oder wärmehärtender Primerlack, versehen werden. Das so erhaltene Erzeugnis kann anschließend mit einer Klebschicht versehen werden, die z.B. auf der der leitfähigen Metallisierung gegenüber liegenden Seite des transparenten Substrats angeordnet ist. Die Klebschicht kann alternativ oberhalb der transparenten, die leitfähige Metallisierung einebnenden Beschichtung angeordnet werden. Als Klebschicht eignet sich z.B. ein Heißsiegellack. Gemäß einer speziellen Variante kann die eingesetzte Klebschicht, z.B. ein Heißsiegellack, mit der für das Einebnen der leitfähigen Metallisierung verwendeten transparenten Beschichtung identisch sein.

Das transparente Substrat ist insbesondere ein Glassubstrat oder eine Kunststofffolie, z.B. eine Polyethylenterephthalat(PET)-Folie.

Gemäß einer weiteren bevorzugten Ausführungsform wird die leitfähige Metallisierung in Form eines dichtmaschigen, zusammenhängenden Netzes so ausgebildet, dass die leitfähige Metallisierung auf einer Mehrschichtanordnung mit drei Schichten basiert, sodass oberhalb und unterhalb der ersten Schicht aus einem leitfähigen Metall jeweils eine weitere Schicht aus dem die visuelle Wahrnehmbarkeit der ersten Schicht verringernden Material angeordnet ist. Diese Ausführungsform hat den Vorteil, dass die Folie für den Betrachter sowohl bei Betrachtung von der Vorderseite als auch bei Betrachtung von der Rückseite einen neutralen Farbeindruck aufweist.

Für das Erzielen einer vorteilhaften Leitfähigkeit wird für die Schicht aus leitfähigem Metall eine Kupferschicht gewählt.

Die vorliegende Erfindung betrifft weiterhin den Aspekt des Herstellens einer transparenten, leitfähigen Folie, umfassend die folgenden Schritte:
- das Bereitstellen eines transparenten Substrats;
- das Aufbringen einer Riss-bildenden Beschichtung auf das transparente Substrat und Trocknen der Riss-bildenden Beschichtung, wobei die Beschichtung beim Trocknen zahlreiche Risse in Form eines dichtmaschigen, zusammenhängenden Netzes ausbildet;
- das Aufbringen einer auf einer Mehrschichtanordnung basierenden leitfähigen Metallisierung, die eine erste Schicht aus einem leitfähigen Metall, nämlich Kupfer, und zumindest eine weitere Schicht aus einem die visuelle Wahrnehmbarkeit der ersten Schicht verringernden Material aufweist;
- das Entfernen der mit Rissen versehenen Beschichtung zusammen mit der oberhalb der Beschichtung vorliegenden Mehrschichtanordnung, sodass das erhaltene transparente Substrat so beschaffen ist, dass auf dessen Hauptfläche die leitfähige Metallisierung in Form eines dichtmaschigen, zusammenhängenden Netzes mit einer Vielzahl von Öffnungen unterschiedlicher geometrischer Form ausbildet ist.

Das erfindungsgemäße Herstellungsverfahren ist an die in der WO 2016/192858 A1 beschriebene Herstellung angelehnt.

Erfindungsgemäß wird als Riss-bildende Beschichtung bevorzugt eine Dispersion, weiter bevorzugt eine kolloidale Dispersion eingesetzt. Insbesondere geeignet sind z.B. Dispersionen aus SiO₂-Nanopartikeln oder aus Acrylharz-Nanopartikeln, beschrieben auf Seite 2090 im Dokument: S. Kiruthika, R. Gupta, K. D. M. Rao, S. Chakraborty, N. Padmavathy, G. U. Kulkarni: "Large area solution processed transparent conducting electrode based on highly interconnected Cu wire network", J. Mater. Chem. C, 2014, Band 2, Seiten 2089-2094. Darüber hinaus kann die Riss-bildende Beschichtung auf einem in Lösung vorliegenden Polymer basieren. Die Polymer-Lösung wird auf das Substrat aufgebracht, z.B. mittels Aufdrucken, sodass ein dünner Polymerfilm erzeugt wird. Der dünne Polymerfilm bildet während des Trocknens Risse aus.

Die Riss-Bildung ist abhängig von der Wahl der Rohstoffe und der Wahl des Substrats, der Schichtdicke der Riss-bildenden Beschichtung und von den Trocknungsparametern. Dabei liegen die am Ende des Herstellungsverfahrens erzielbaren Linienstärken z.B. im Falle von Silber im Bereich von 1 µm bis 50 µm, wobei die Linien in der Regel so fein sind, dass sie erst beim Einsatz einer Lupe als Linien erkennbar sind. In der Fläche löst das menschliche Auge die einzelnen Linien nicht auf, man erkennt aber sowohl im Auflicht (bzw. Reflexion), als auch im Durchlicht (bzw. Transmission) einen Unterschied gegenüber der unbehandelten bzw. bloßen Folie. Da die feinen Linien ein unregelmäßiges, zusammenhängendes Netz bilden, können unerwünschte Beugungseffekte minimiert werden. Durch Variation der Insel-Größe und der Riss-Breite kann das Reflexionsvermögen bzw. die Licht-Durchlässigkeit in geeigneter Weise eingestellt werden.

Das Verfahren zum Entfernen der mit Rissen versehenen Beschichtung erfolgt mit Vorteil mittels Auflösen mit einem geeigneten Lösungsmittel. Die Wahl des Lösungsmittels erfolgt zweckmäßigerweise in Abstimmung auf die Beschichtung. Typischerweise können die folgenden Lösungsmittel verwendet werden: Methylacetat, Ethylacetat, Propylacetat, Butylacetat, Methoxypropylacetat, Aceton, Methylethylketon, Methylisobutylketon, Cyclopentanon, Cyclohexanon, Methylenchlorid, Chloroform, Toluol, Xylol, Methanol, Ethanol, 2-Propanol. Weiterhin können Acetale oder Gemische der vorstehend genannten Lösungsmittel verwendet werden. Alternativ kann auch ein Ablösen der Riss-bildenden Beschichtung durch Unterwanderung erfolgen. In diesem Fall können neben den genannten Lösungsmitteln auch wässrige Lösungen, Mischungen von Lösungsmitteln und Wasser, ggf. mit Tensiden, ggf. mit Entschäumern und sonstigen Additiven zum Einsatz kommen. Die Ablösung bzw. Auflösung der mit Rissen versehenen Beschichtung kann auch durch Spritzdüsen oder auch mechanisch durch Bürsten, Walzen oder durch Filze unterstützt werden.

Die erfindungsgemäße Metallisierung in Form eines dichtmaschigen, zusammenhängenden Netzes zeigt eine elektrische Leitfähigkeit sowie eine optische Transmission, die mit einer vollflächigen ITO-Schicht vergleichbar ist. Dabei können die feinen metallischen Linien in Kombination mit üblichen Prägelacken, üblichen Primer-Zusammensetzungen und üblichen Heißsiegellacken eingesetzt werden und dabei als Reflektor fungieren.

Die erfindungsgemäße transparente, leitfähige Folie eignet sich insbesondere zur Anwendung in elektrischen Vorrichtungen, z.B. als Heizfolie zur Verwendung in der Windschutzscheibe eines Fahrzeugs, in sonstigen Fenstern oder in der Gebäudeverglasung, sowie zur Stromeinkopplung ohne sichtbare Zuleitungen, z.B. zur Verwendung in LED-Folien, in Solarzellen, in Smart-Glass-Anwendungen, in OLEDs oder in Touch Panels.

Weitere Ausführungsbeispiele sowie Vorteile der Erfindung werden nachfolgend anhand der Figuren erläutert, bei deren Darstellung auf eine maßstabs- und proportionsgetreue Wiedergabe verzichtet wurde, um die Anschaulichkeit zu erhöhen.

Es zeigen:
- Figuren 1 - 8: die einzelnen Herstellungsschritte für das Erhalten einer transparenten, leitfähigen Folie gemäß einem ersten Ausführungsbeispiel; und
- Figuren 9 - 13: die einzelnen Herstellungsschritte für das Erhalten einer transparenten, leitfähigen Folie gemäß einem zweiten Ausführungsbeispiel.

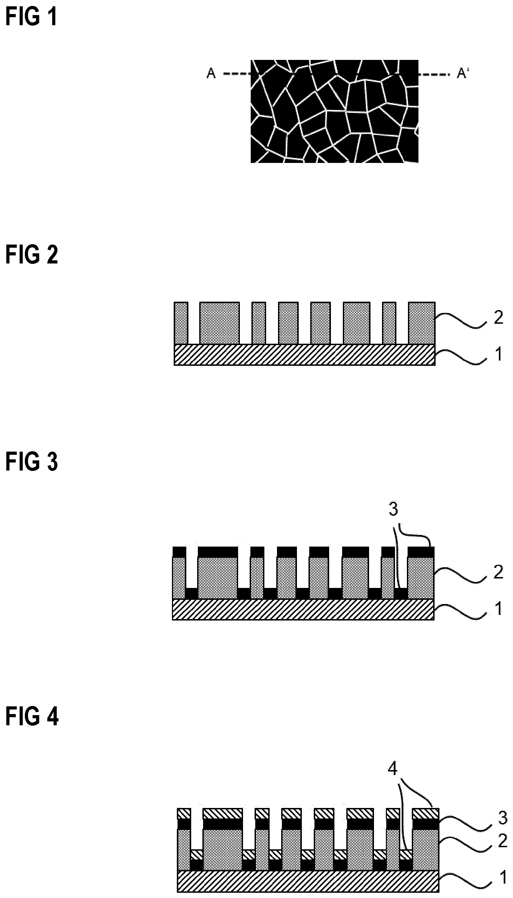

Die Figuren 1 bis 8 veranschaulichen die einzelnen Herstellungsschritte für das Erhalten einer transparenten, leitfähigen Folie gemäß einem ersten Ausführungsbeispiel.

Gemäß den Figuren 1 und 2 erfolgt zunächst das Bereitstellen eines transparenten Substrats 1, im vorliegenden Fall eine PET-Folie, und das Versehen des Substrats 1 mit einer Riss-bildenden Beschichtung 2. Die Riss-bildende Beschichtung 2 basiert z.B. auf Dispersionen aus SiO₂-Nanopartikeln oder aus Acrylharz-Nanopartikeln. Das Aufbringen der Riss-bildenden Beschichtung 2 erfolgt bevorzugt drucktechnisch, z.B. mittels Tiefdruck, Flexodruck oder mittels eines Inkjet-Verfahrens. Die Riss-bildende Beschichtung 2 bildet beim Trocknen zahlreiche Risse in Form eines dichtmaschigen, zusammenhängenden Netzes aus.

Die Figur 1 zeigt die mit Rissen versehene Beschichtung 2 bei der Betrachtung in Draufsicht. Die Figur 2 zeigt eine Querschnittansicht entlang der gestrichelten Linie A-A'.

In einem weiteren Schritt erfolgt das Aufbringen einer auf unterstöchiometrischem, schwarzen Aluminiumoxid basierenden Schicht 3 (siehe Figur 3). Die auf unterstöchiometrischem, schwarzen Aluminiumoxid basierende Schicht 3 wird sowohl oberhalb der mit Rissen versehenen Beschichtung 2 als auch innerhalb der Risse der Beschichtung 2 abgeschieden.

In einem weiteren Schritt erfolgt das Aufbringen einer leitfähigen Cu-Schicht 4, (siehe Figur 4). Die Cu- Schicht 4 wird sowohl oberhalb der mit Rissen versehenen Beschichtung 2 als auch innerhalb der Risse der Beschichtung 2 abgeschieden.

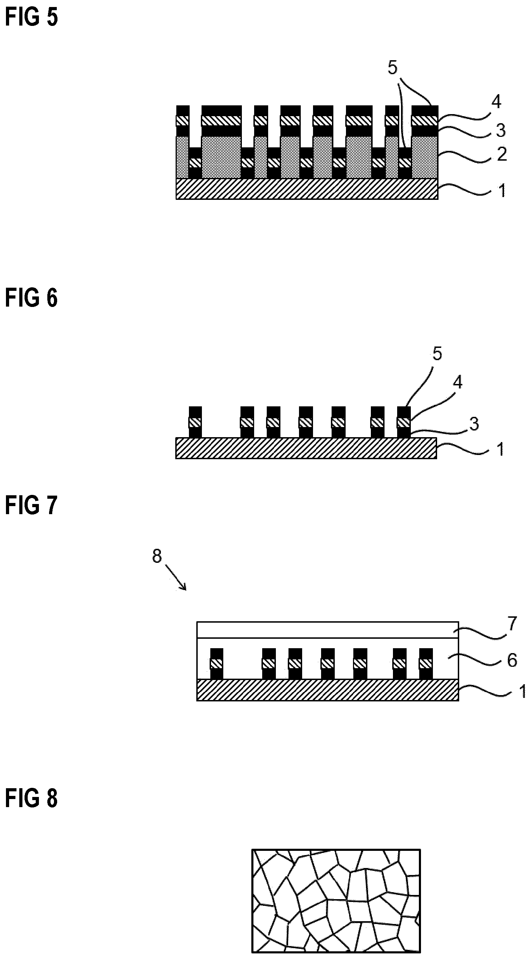

In einem weiteren Schritt erfolgt das Aufbringen einer weiteren auf unterstöchiometrischem, schwarzen Aluminiumoxid basierenden Schicht 5 (siehe Figur 5). Die auf unterstöchiometrischem, schwarzen Aluminiumoxid basierende Schicht 5 wird sowohl oberhalb der mit Rissen versehenen Beschichtung 2 als auch innerhalb der Risse der Beschichtung 2 abgeschieden.

Gemäß der Figur 6 erfolgt anschließend das Entfernen der mit Rissen versehenen Beschichtung 2 inklusive der oberhalb der Beschichtung 2 vorhandenen Schichten 3, 4 und 5 in einem Waschschritt. Das Waschen erfolgt mittels Auflösen mit einem geeigneten Lösungsmittel, z.B. Methylacetat. Auf dem transparenten Substrat 1 verbleibt eine transparente, leitfähige Metallisierung in Form eines dichtmaschigen, zusammenhängenden Netzes. Die leitfähige Metallisierung basiert auf einer Mehrschichtanordnung mit drei Schichten, wobei oberhalb und unterhalb der leitfähigen Cu-Schicht 4 zwei weitere Schichten 3, 5 aus die visuelle Wahrnehmbarkeit der Cu-Schicht 4 verringerndem, unterstöchiometrischen, schwarzen Aluminiumoxid angeordnet sind.

Die Figur 8 zeigt die transparente, leitfähige Metallisierung in Form eines dichtmaschigen, zusammenhängenden Netzes schematisch in Draufsicht in vergrößerter Darstellung.

Gemäß der Figur 7 kann optional das Aufbringen eines transparenten, einebnenden Lacks 6 erfolgen. Eine gegebenenfalls vorhandene Klebschicht 7, z.B. eine Heißsiegellackschicht, dient für das Aufbringen der transparenten, leitfähigen Folie 8 z.B. auf die Windschutzscheibe eines Fahrzeugs.

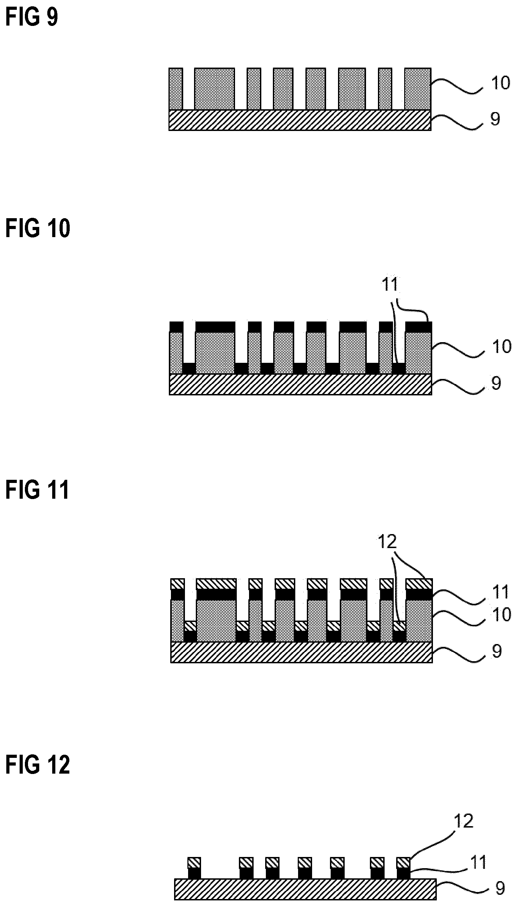

Die Figuren 9 bis 13 veranschaulichen die einzelnen Herstellungsschritte für das Erhalten einer transparenten, leitfähigen Folie gemäß einem zweiten Ausführungsbeispiel. Die Herstellung ist an das erste Ausführungsbeispiel angelehnt.

Gemäß der Figur 9 erfolgt zunächst das Bereitstellen eines transparenten Substrats 9, im vorliegenden Fall ein Glassubstrat, und das Versehen des Substrats 9 mit einer Riss-bildenden Beschichtung 10. Die Riss-bildende Beschichtung 10 bildet beim Trocknen zahlreiche Risse in Form eines dichtmaschigen, zusammenhängenden Netzes aus.

In einem weiteren Schritt erfolgt das Aufbringen einer Kupferoxid-Schicht 11 (siehe Figur 10). Die Kupferoxid-Schicht 11 wird sowohl oberhalb der mit Rissen versehenen Beschichtung 10 als auch innerhalb der Risse der Beschichtung 10 abgeschieden.

In einem weiteren Schritt erfolgt das Aufbringen einer leitfähigen Schicht 12, im vorliegenden Fall eine Ag-Schicht (siehe Figur 11). Die Ag-Schicht 12 wird sowohl oberhalb der mit Rissen versehenen Beschichtung 10 als auch innerhalb der Risse der Beschichtung 10 abgeschieden.

Gemäß der Figur 12 erfolgt anschließend das Entfernen der mit Rissen versehenen Beschichtung 10 inklusive der oberhalb der Beschichtung 10 vorhandenen Schichten 11 und 12 in einem Waschschritt. Auf dem transparenten Substrat 9 verbleibt eine transparente, leitfähige Metallisierung in Form eines dichtmaschigen, zusammenhängenden Netzes. Die leitfähige Metallisierung basiert auf einer Mehrschichtanordnung mit zwei Schichten, wobei unterhalb der leitfähigen Ag-Schicht 12 die Schicht 11 aus die visuelle Wahrnehmbarkeit der Ag-Schicht 12 verringerndem, schwarzen Kupferoxid angeordnet ist.

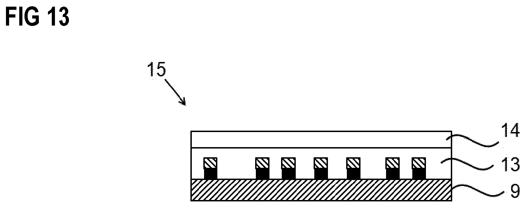

Gemäß der Figur 13 kann optional das Aufbringen eines transparenten, einebnenden Lacks 13 erfolgen. Eine gegebenenfalls vorhandene Klebschicht 14, z.B. eine Heißsiegellackschicht, dient für das Aufbringen der transparenten, leitfähigen Folie 15 z.B. auf die Windschutzscheibe eines Fahrzeugs.

## Patentansprüche

1. Transparente, leitfähige Folie, umfassend ein transparentes Substrat, auf dessen Hauptfläche eine leitfähige Metallisierung in Form eines dichtmaschigen, zusammenhängenden Netzes mit einer Vielzahl von Öffnungen unterschiedlicher geometrischer Form ausbildet ist, wobei die leitfähige Metallisierung auf einer Mehrschichtanordnung basiert, die eine erste Schicht aus einem leitfähigen Metall, nämlich Kupfer, und zumindest eine weitere Schicht aufweist, **dadurch gekennzeichnet, dass** die zumindest eine weitere Schicht aus einem die visuelle Wahrnehmbarkeit der ersten Schicht verringernden Material ist, sodass ein neutraler Farbeindruck mit geringer Reflexion herbeigeführt wird, wobei die zumindest eine weitere Schicht aus einem die visuelle Wahrnehmbarkeit der ersten Schicht verringernden Material von der Gruppe bestehend aus einer Metalloxidschicht, einem antireflektierenden Dünnschichtaufbau mit der Schichtenfolge Metall/Dielektrikum/Metall oder der Schichtenfolge Dielektrikum/Metall/Dielektrikum/Metall, Schwarzchrom, Schwarznickel, einer Metallsulfidschicht, einem auf einem Farblack oder einem Pigmentlack basierenden Überdruck, einer durch eine Nanostrukturierung bzw. Mottenaugenstruktur gebildete Antireflexionsschicht und einer Kombination zweier oder mehrerer der vorstehend genannten Elemente gewählt ist.

2. Transparente, leitfähige Folie nach Anspruch 1, wobei die zumindest eine weitere Schicht aus einem die visuelle Wahrnehmbarkeit der ersten Schicht verringernden Material, nämlich Kupferoxid, Chromoxid oder eine auf einem unterstöchiometrischen Aluminiumoxid basierende Metalloxidschicht, gewählt ist.

3. Transparente, leitfähige Folie nach Anspruch 1 oder 2, wobei ausgehend vom transparenten Substrat die erste Schicht aus leitfähigem Metall und darauffolgend die zumindest eine weitere Schicht aus dem die visuelle Wahrnehmbarkeit der ersten Schicht verringernden Material in der Reihenfolge angeordnet sind.

4. Transparente, leitfähige Folie nach Anspruch 1 oder 2, wobei die leitfähige Metallisierung auf einer Mehrschichtanordnung mit drei Schichten basiert, sodass oberhalb und unterhalb der ersten Schicht aus einem leitfähigen Metall jeweils eine weitere Schicht aus dem die visuelle Wahrnehmbarkeit der ersten Schicht verringernden Material angeordnet ist.

5. Transparente, leitfähige Folie nach einem der Ansprüche 1 bis 4, wobei die Folie zusätzlich eine die leitfähige Metallisierung einebnende Schicht und eine Klebschicht aufweist.

6. Verfahren zum Herstellen einer transparenten, leitfähigen Folie nach einem der Ansprüche 1 bis 5, umfassend die folgenden Schritte:
- das Bereitstellen eines transparenten Substrats;
- das Aufbringen einer Riss-bildenden Beschichtung auf das transparente Substrat und Trocknen der Riss-bildenden Beschichtung, wobei die Beschichtung beim Trocknen zahlreiche Risse in Form eines dichtmaschigen, zusammenhängenden Netzes ausbildet;
- das Aufbringen einer auf einer Mehrschichtanordnung basierenden leitfähigen Metallisierung, die eine erste Schicht aus einem leitfähigen Metall und zumindest eine weitere Schicht aus einem die visuelle Wahrnehmbarkeit der ersten Schicht verringernden Material aufweist;
- das Entfernen der mit Rissen versehenen Beschichtung zusammen mit der oberhalb der Beschichtung vorliegenden Mehrschichtanordnung, sodass das erhaltene transparente Substrat so beschaffen ist, dass auf dessen Hauptfläche die leitfähige Metallisierung in Form eines dichtmaschigen, zusammenhängenden Netzes mit einer Vielzahl von Öffnungen unterschiedlicher geometrischer Form ausbildet ist.

7. Verwendung der transparenten, leitfähigen Folie nach einem der Ansprüche 1 bis 5 als Heizfolie, insbesondere in der Windschutzscheibe eines Fahrzeugs, in sonstigen Fenstern oder in der Gebäudeverglasung, sowie zur Stromeinkopplung ohne sichtbare Zuleitungen, z.B. zur Verwendung in LED-Folien, in Solarzellen, in Smart-Glass-Anwendungen, in OLEDs oder in Touch Panels.

## Claims

1. A transparent, conductive film comprising a transparent substrate on the main surface of which a conductive metallization is formed in the form of a dense, continuous mesh with a plurality of openings of varying geometric shapes, wherein the conductive metallization is based on a multilayer structure comprising a first layer of a conductive metal, namely copper, and at least one additional layer, **characterized in that** the at least one additional layer consists of a material that reduces the visual perceptibility of the first layer, thereby producing a neutral color impression with low reflectance, wherein the at least one additional layer consists of a material that reduces the visual perceptibility of the first layer, selected from the group consisting of a metal oxide layer, an antireflective thin-film structure with the layer sequence metal/ dielectric/ metal or the layer sequence dielectric/ metal/ dielectric/ metal, black chrome, black nickel, a metal sulfide layer, an overprint based on a colored lacquer or a pigmented lacquer, an antireflective layer formed by nanostructuring or a moth-eye structure, and a combination of two or more of the aforementioned elements.

2. A transparent, conductive film according to claim 1, wherein the at least one additional layer is selected from a material that reduces the visual perceptibility of the first layer, namely copper oxide, chromium oxide, or a metal oxide layer based on substoichiometric aluminum oxide.

3. A transparent, conductive film according to claim 1 or 2, wherein, starting from the transparent substrate, the first layer of conductive metal and, subsequently, the at least one additional layer of the material that reduces the visual perceptibility of the first layer are arranged in that order.

4. A transparent, conductive film according to claim 1 or 2, wherein the conductive metallization is based on a multilayer structure comprising three layers, such that one additional layer of the material that reduces the visual perceptibility of the first layer is arranged above and below the first layer of a conductive metal, respectively.

5. A transparent, conductive film according to any one of claims 1 through 4, wherein the film additionally comprises a layer that levels the conductive metallization and an adhesive layer.

6. A method for manufacturing a transparent, conductive film according to any one of claims 1 through 5, comprising the following steps:
- providing a transparent substrate;
- applying a crack-forming coating to the transparent substrate and drying the crack-forming coating, wherein the coating forms numerous cracks in the form of a dense, continuous network during drying;
- applying a conductive metallization based on a multilayer assembly, comprising a first layer of a conductive metal and at least one additional layer of a material that reduces the visual perceptibility of the first layer;
- removing the cracked coating together with the multilayer assembly located above the coating, so that the resulting transparent substrate is such that the conductive metallization is formed on its main surface in the form of a dense, continuous network with a multitude of openings of varying geometric shapes.

7. Use of the transparent, conductive film according to any one of claims 1 through 5 as a heating film, in particular in a vehicle windshield, in other windows, or in building glazing, as well as for power coupling without visible leads, e.g., for use in LED films, in solar cells, in smart glass applications, in OLEDs, or in touch panels.

## Revendications

1. Film transparent conducteur, comprenant un substrat transparent sur la surface principale duquel est formée une métallisation conductrice sous la forme d'un réseau continu à mailles serrées comportant une multitude d'ouvertures de formes géométriques différentes, la métallisation conductrice étant basée sur un assemblage multicouche comprenant une première couche d'un métal conducteur, à savoir du cuivre, et d'au moins une autre couche, **caractérisé en ce que** ladite au moins une autre couche est constituée d'un matériau réduisant la perceptibilité visuelle de la première couche, de manière à produire une impression de couleur neutre avec une faible réflexion, cette au moins une autre couche étant constituée d'un matériau réduisant la perceptibilité visuelle de la première couche, choisi parmi le groupe comprenant une couche d'oxyde métallique, une structure en couches minces antireflet présentant la séquence de couches métal/diélectrique/métal ou la séquence de couches
diélectrique/ métal/ diélectrique/ métal, le chrome noir, du nickel noir, d'une couche de sulfure métallique, d'une surcouche à base de laque colorée ou de laque pigmentée, d'une couche antireflet formée par une nanostructuration ou une structure en « œil de papillon », et d'une combinaison de deux ou plusieurs des éléments susmentionnés.

2. Film conducteur transparent selon la revendication 1, dans lequel ladite au moins une autre couche est choisie parmi un matériau réduisant la perceptibilité visuelle de la première couche, à savoir l'oxyde de cuivre, l'oxyde de chrome ou une couche d'oxyde métallique à base d'oxyde d'aluminium sous-steechiométrique.

3. Film transparent et conducteur selon la revendication 1 ou 2, dans lequel, à partir du substrat transparent, la première couche de métal conducteur est disposée, suivie de la au moins une autre couche constituée du matériau réduisant la visibilité de la première couche, dans cet ordre.

4. Film transparent et conducteur selon la revendication 1 ou 2, dans lequel la métallisation conductrice repose sur un assemblage multicouche à trois couches, de sorte qu'au-dessus et au-dessous de la première couche constituée d'un métal conducteur se trouve respectivement une autre couche constituée du matériau réduisant la perceptibilité visuelle de la première couche.

5. Film transparent et conducteur selon l'une des revendications 1 à 4, le film comportant en outre une couche lissant la métallisation conductrice et une couche adhésive.

6. Procédé de fabrication d'un film conducteur transparent selon l'une des revendications 1 à 5, comprenant les étapes suivantes :
- la mise à disposition d'un substrat transparent ;
- l'application d'un revêtement fissurant sur le substrat transparent et le séchage de ce revêtement, celui-ci formant, lors du séchage, de nombreuses fissures sous la forme d'un réseau continu à mailles serrées ;
- l'application d'une métallisation conductrice basée sur un assemblage multicouche, qui comporte une première couche d'un métal conducteur et au moins une autre couche d'un matériau réduisant la visibilité de la première couche ;
- l'élimination du revêtement fissuré ainsi que de l'assemblage multicouche situé au-dessus de ce revêtement, de sorte que le substrat transparent obtenu présente, sur sa surface principale, une métallisation conductrice sous la forme d'un réseau continu à mailles serrées comportant une multitude d'ouvertures de formes géométriques différentes.

7. Utilisation du film transparent et conducteur selon l'une des revendications 1 à 5 comme film chauffant, en particulier dans le pare-brise d'un véhicule, dans d'autres vitres ou dans le vitrage de bâtiments, ainsi que pour l'injection de courant sans câbles d'alimentation visibles, par exemple pour une utilisation dans des films LED, dans des cellules solaires, dans des applications de verre intelligent, dans les OLED ou dans les écrans tactiles.
